(19) **Europäisches Patentamt / European Patent Office / Office européen des brevets**

(11) **EP 2 135 108 B1**

(12) **FASCICULE DE BREVET EUROPEEN**

(45) Date de publication et mention de la délivrance du brevet: **21.06.2017 Bulletin 2017/25**

(51) Int Cl.:
*G01S 1/00* (2006.01)  *H03L 7/085* (2006.01)

(21) Numéro de dépôt: **08717573.3**

(22) Date de dépôt: **10.03.2008**

(86) Numéro de dépôt international: **PCT/EP2008/052826**

(87) Numéro de publication internationale: **WO 2008/113708 (25.09.2008 Gazette 2008/39)**

(54) **DISPOSITIF DE RECEPTION DE SIGNAUX SATELLITAIRES COMPRENANT UNE BOUCLE DE PHASE AVEC COMPENSATION DES RETARDS**

**VORRICHTUNG FÜR DEN EMPFANG VON SATELLITENSIGNALEN MIT PHASENSCHLEIFE MIT VERZÖGERUNGSKOMPENSATION**

**DEVICE FOR RECEIVING SATELLITE SIGNALS INCLUDING A PHASE LOOP WITH DELAY COMPENSATION**

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **16.03.2007 FR 0701931**

(43) Date de publication de la demande:
**23.12.2009 Bulletin 2009/52**

(73) Titulaire: **THALES**
**92400 Courbevoie (FR)**

(72) Inventeurs:
• **MARTIN, Nicolas**
**26500 Bourg Les Valence (FR)**
• **DEPRAZ, David**
**26000 Valence (FR)**
• **GUILLARD, Patrice**
**26000 Valence (FR)**

(74) Mandataire: **Bréda, Jean-Marc et al**
**Marks & Clerk France**
**Conseils en Propriété Industrielle**
**Immeuble " Visium "**
**22 Avenue Aristide Briand**
**94117 Arcueil Cedex (FR)**

(56) Documents cités:
**WO-A-2004/105248**

• **HINEDI S ET AL: "DIGITAL ACCUMULATORS IN PHASE AND FREQUENCY TRACKING LOOPS" IEEE TRANSACTIONS ON AEROSPACE AND ELECTRONIC SYSTEMS, IEEE SERVICE CENTER, PISCATAWAY, NJ, US, vol. 26, no. 1, 1 janvier 1990 (1990-01-01), pages 169-180, XP000104247 ISSN: 0018-9251**

**Description**

Le domaine technique de l'invention est celui de la radionavigation par satellite. Il concerne l'actuel système dit « GPS », acronyme de Global Positioning System et le futur système « Galileo ». Le domaine technique concerné est plus particulièrement celui des moyens de démodulation des systèmes de réception.

La radionavigation par satellite permet d'obtenir la position d'un récepteur de signaux par une résolution voisine de la triangulation, utilisant les pseudo-distances mesurées à partir des signaux envoyés par plusieurs satellites. Chaque satellite émet un signal constitué d'une porteuse sinusoïdale dont la fréquence est comprise entre 1.2 et 1.6 GHz. Cette porteuse est modulée par un code d'étalement binaire dont la fréquence est comprise entre 1 à 10 MHz.

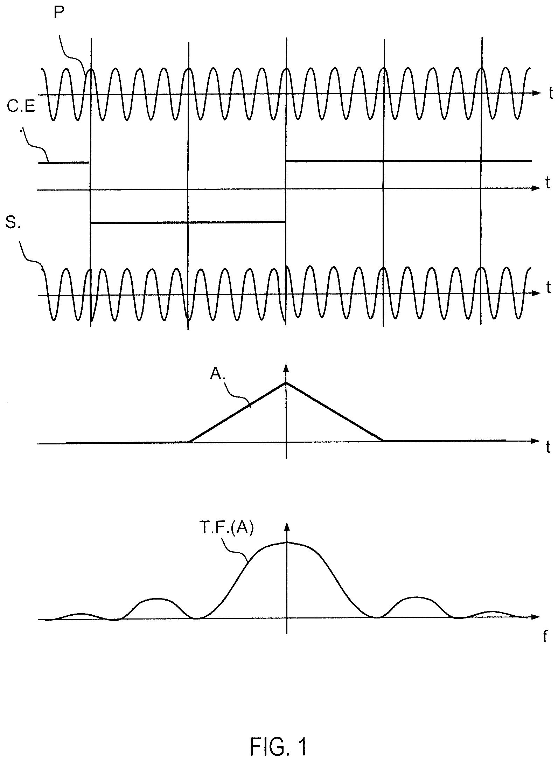

La figure 1 représente un premier signal S émis modulé par son code d'étalement C.E.. Le premier graphique de cette figure 1 représente les variations sinusoïdales de la porteuse P initiale en fonction du temps t, le second représente le code d'étalement C.E., le troisième représente la porteuse modulée par son code d'étalement S, le quatrième la fonction d'autocorrélation A du code local, enfin le cinquième graphique représente son spectre de puissance en fonction de la fréquence f.

La porteuse peut également être modulée par des bits de données dont la fréquence est comprise entre 1 Hz à 50 Hz. La séquence d'étalement a une période variant de une milliseconde à une semaine. Elle est propre à chaque satellite et les séquences sont décorrélées entre les différents satellites, permettant de les dissocier dans le signal reçu.

Un satellite émet soit un signal de données seul, soit un signal de données et un signal dit pilote non modulé par des bits de données.

Le récepteur comporte une antenne de réception et des moyens de démodulation des signaux émis par les satellites visibles. Ces moyens de démodulation corrèlent le signal reçu par l'antenne avec une porteuse locale et un code local propres à chaque satellite. C'est la séquence du code local, identique à celle du satellite reçu, qui permet au récepteur de choisir le satellite poursuivi.

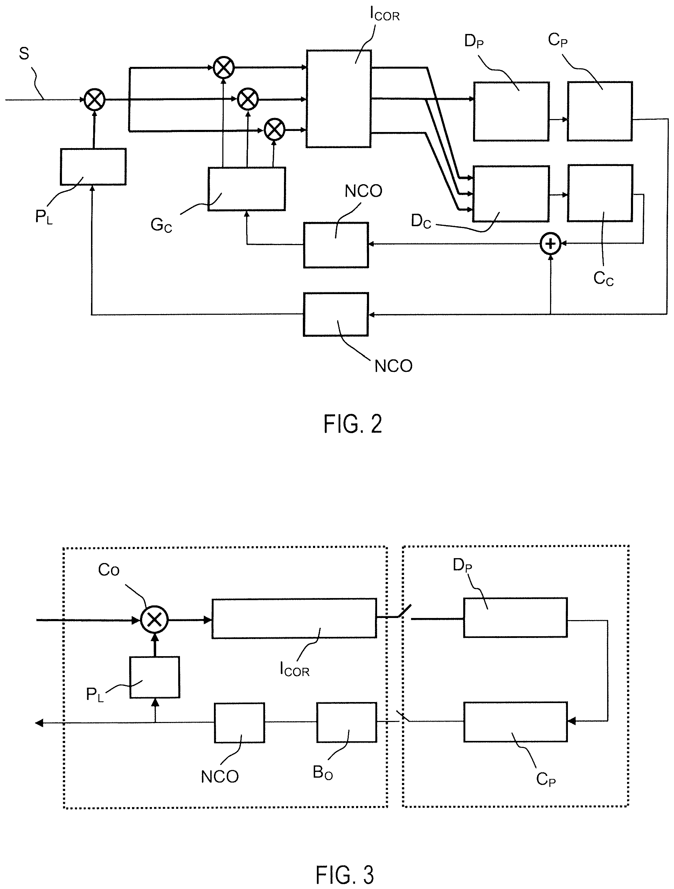

Pour synchroniser le code local et la porteuse locale sur le signal reçu du satellite contenu dans le signal reçu par l'antenne, le récepteur utilise en parallèle deux dispositifs de poursuite qui sont une boucle de code et une boucle de porteuse. Les synoptiques fonctionnels de ces boucles sont représentés sur la figure 2 et sont détaillés ci-dessous.

La boucle de code sert à positionner un code local en phase avec le code contenu dans le signal satellite S reçu de manière à réaliser une corrélation donnant le maximum d'énergie.

La boucle de porteuse sert à asservir la fréquence ou la phase de la porteuse locale avec respectivement la fréquence ou la phase de la porteuse reçue, afin de maximiser le résultat de la corrélation.

Des dispositifs de poursuite pour des applications de ce type sont décrits dans la publication intitulée « Digital Accumulators in phase and frequency tracking Loops » de Hinedi et AI, IEEE Transactions on Aerospace and Electronic Systems, Vol. 26, N° 1, Janvier 1990.

La présence d'un signal en sortie de la corrélation avec une amplitude importante, c'est-à-dire nettement supérieure à ce que donnerait le bruit ambiant en l'absence de signal satellite signifie que le code local et la porteuse locale sont synchronisés sur le signal reçu, ce qui permet de mesurer à chaque instant la date d'émission et le Doppler du signal reçu, par l'intermédiaire de la phase du code local et de la vitesse de la phase de la porteuse locale.

La synchronisation initiale de la phase du code local et de la porteuse locale sur le signal reçu du satellite est réalisée dans une phase préliminaire dite d'acquisition. Cette phase n'est pas détaillée dans cette description car elle sort du cadre du dispositif selon l'invention. Elle est bien connue de l'homme du métier et ne pose pas de difficultés particulières. De façon générale, elle consiste en une recherche d'énergie par balayage d'un domaine d'incertitude en code et en Doppler jusqu'à ce que la corrélation donne un niveau de signal suffisant.

Plus précisément, comme indiqué en figure 2, la boucle de code utilise au moins deux voies de corrélation, avec un code local en avance et un code local en retard par rapport au code de référence de la voie ponctuelle, la porteuse locale étant commune aux trois voies. Ces voies de corrélation sont représentées par les trois flèches issues de l'intégrateur de corrélation $I_{COR}$. La boucle cherche à égaliser les niveaux en sortie des deux voies de corrélation par une rétro-action sur la phase du code local grâce à :

- Un générateur de code $G_C$ ;
- Un intégrateur de corrélation $I_{COR}$ qui réalise l'intégration de la corrélation ;
- un discriminateur de code $D_C$ qui mesure la différence d'énergie entre les deux voies ;
- un correcteur de boucle $C_C$ qui filtre le discriminateur et produit une correction en vitesse ;
- un opérateur de contrôle numérique encore appelé NCO qui transforme la commande en vitesse en une phase de code local.

Lorsque les deux niveaux sont égaux, le code de référence de la voie ponctuelle est en phase avec le code du satellite reçu, ce qui assure un maximum de rendement de la corrélation sur cette voie, hormis la perte due à l'effet Doppler, si la fréquence de la porteuse locale n'est pas bien asservie sur celle de la porteuse reçue.

Il existe deux types de boucle de porteuse : les boucles de fréquence et les boucles de phase de porteuse.

Une boucle de fréquence sert à faire coïncider la fréquence de la porteuse locale avec celle de la porteuse reçue, en premier lieu pour maximiser le signal recueilli après la corrélation et en second lieu pour fournir une mesure de Doppler sur le satellite poursuivi.

Une boucle de phase sert à asservir la phase de la porteuse locale sur la phase de la porteuse reçue à modulo $2\pi$ près dans le but d'améliorer la précision de la mesure de code grâce à un lissage du code par la phase de la porteuse. Une boucle de phase fournit une information beaucoup plus riche qu'une boucle de fréquence, car les évolutions de la phase de porteuse mesurée traduisent très précisément les évolutions des pseudo-distances, sans dérive, contrairement aux mesures d'une boucle de fréquence intégrée. C'est cette propriété qui permet d'améliorer grandement la précision de la mesure de code par un filtrage sur un temps très long. On filtre l'écart entre la mesure de pseudo-distance de code et la mesure de pseudo-distance de porteuse puis on corrige la mesure de phase de cet écart filtré pour retrouver une mesure de code très précise.

Une boucle de phase de porteuse, encore appelée en terminologie anglo-saxonne PLL, signifiant Phase Lock Loop ou boucle à verrouillage de phase, utilise la voie de corrélation ponctuelle et asservit la phase de la porteuse locale sur la phase de la porteuse reçue par une rétro-action sur la phase locale grâce à :

- un discriminateur de phase $D_P$ qui mesure l'écart entre la phase locale et la phase reçue ;
- un correcteur de boucle $C_P$ qui filtre le discriminateur et produit une correction en vitesse ;
- un NCO porteuse qui transforme la commande en vitesse en une phase de porteuse locale $P_L$.

En fait, la commande NCO est l'image du Doppler et le NCO produit une phase à la fréquence $f_{code}$ ou $f_{porteuse}$ dite talon, augmentée de la commande en vitesse Doppler, positive ou négative.

Les critères de performances des boucles de poursuite sont :

- la précision ;
- la robustesse. On entend par robustesse la capacité d'une boucle à rester accrochée et donc à limiter l'erreur de phase dans un domaine borné. Les facteurs affectant la robustesse sont :

  - les différents bruits qui peuvent être le bruit thermique ambiant, le bruit dû à des interférences, l'atténuation du signal utile,...;
  - la dynamique dû au mouvement du porteur ou aux défauts de l'horloge.

Grâce notamment au lissage du code par la porteuse, la précision de quelques dizaines de centimètres du code est en général suffisante tant que la boucle de phase reste accrochée.

De même, la précision de quelques millimètres de la porteuse est suffisante pour la plupart des applications.

La boucle de code est aidée en vitesse par la boucle de porteuse, la commande NCO code étant la somme de la sortie du correcteur de code et de la commande NCO porteuse comme on le voit sur la figure 2, cette somme étant symbolisé par le symbole + entouré. La boucle de code peut avoir une bande passante étroite, la robustesse de la boucle de code au bruit et à la dynamique étant liée à celle de la porteuse. Tant que la porteuse reste accrochée, la boucle de code reste accrochée et la précision reste bonne. Concernant la robustesse du récepteur, son point faible est donc la boucle de phase de porteuse. Pour améliorer la tenue au bruit, il faudrait en minimiser la bande passante. Pour améliorer la tenue à la dynamique, il faudrait en maximiser la bande passante. Il y a donc un compromis à réaliser.

Dans les récepteurs actuels la réalisation des boucles de poursuite est partagée en deux composantes :

- une partie travaillant à haute fréquence réalisée par des composants électroniques de type ASIC ou FPGA, la fréquence de travail allant de 1 MHz à 100 MHz ;
- une partie travaillant à basse fréquence réalisée en logiciel, la fréquence de mesure étant située autour de 50 Hz

A titre d'exemple, la figure 3 représente une boucle de porteuse. La partie matérielle est représentée dans le premier rectangle en pointillés à gauche de la figure 3. Elle comprend :

- un bloqueur d'ordre 0 $B_0$ ;
- un NCO porteuse qui est en fait un intégrateur piloté en vitesse Doppler et générant la phase locale porteuse ;
- une table de fonctions trigonométriques en sinus et cosinus générant la porteuse locale $P_L$ ;
- un corrélateur Cor effectuant la corrélation des signaux locaux avec le signal reçu, symbolisé par le symbole x entouré ;
- des moyens d'intégration $I_{COR}$ par intervalles de durée T coïncidant avec la fréquence basse du logiciel ;

La partie logicielle est représentée dans le second rectangle en pointillés à droite de la figure 3. La partie logicielle assure le pilotage des NCO, à partir du résultat de la corrélation produit à basse fréquence par la partie matérielle. Elle comprend essentiellement un discriminateur de phase $D_P$ et un correcteur de boucle de code $C_P$. Dans toute la suite de la description, on note T la durée ou le temps de cycle d'une tâche élémentaire du logiciel.

La réalisation pratique des boucles de poursuite induit deux sources de retard :

- Le retard dû au temps de calcul de la commande NCO par le logiciel ;
- Le retard dû au NCO qui est piloté en vitesse et non en phase instantanée.

La boucle de code étant aidée en vitesse par la boucle de porteuse, elle a une bande passante petite par rapport à la fréquence des boucles, ces retards n'ont pas de conséquence notable sur les performances de la boucle de code.

Par contre, les retards dans la boucle de porteuse on la fâcheuse conséquence de rendre instable le comportement en boucle fermée, ce qui oblige à maintenir une bande de boucle petite devant la bande de pré-détection $B_{FI}$ égal à 1/T qui correspond à l'inverse de la fréquence de travail de la partie logicielle. Si on ne compense pas les retards dans la boucle de phase de porteuse, il est nécessaire de garder une marge de stabilité entre la bande de pré-détection et la bande de boucle. Cela conduit à avoir une bande de boucle plus petite et donc une tenue à la dynamique moindre.

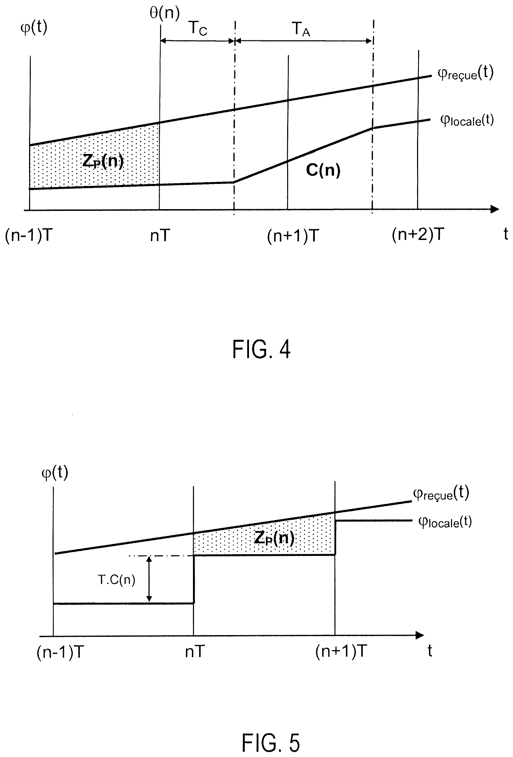

Le retard dû au temps de calcul peut être minimisé par une optimisation de l'architecture logicielle, mais cela induit des coûts de développement supplémentaires, des pics de charge préjudiciables au bon fonctionnement et une incertitude sur le retard d'application de la commande. La figure 4 illustre ce retard. Cette figure représente les variations des différentes phases en fonction du temps de cycle T. Le temps t est découpé en N périodes de durée T, chaque période étant indicée nT, n étant un entier. La première courbe représente la phase locale, la seconde courbe représente la phase reçue. La surface pointillée en forme de trapèze représente l'argument du signal complexe Zp(n) issu de l'intégrateur de corrélation. Le discriminateur de phase est représenté par l'angle θ(n). La pente de la phase locale à la fin du temps de calcul et pendant le temps d'application est notée C(n+1). Comme on le voit sur cette figure 4, le retard dû au temps de calcul $T_C$ entraîne une incertitude sur le retard d'application de la commande.

Le retard dû au ralliement du NCO peut être annulé en repositionnant instantanément la phase en sortie du NCO à partir d'une commande qui serait non plus en vitesse mais en saut. Ce point est illustré en figure 5 en utilisant les mêmes notations que précédemment. Cependant cela n'est pas compatible du Doppler et obligerait à piloter le NCO à la fois en saut et en vitesse, d'où une complexité accrue du récepteur.

La méthode proposée permet d'augmenter la bande de boucle donc la tenue à la dynamique sans changer la bande de pré-détection donc la charge de travail du logiciel.

Elle permet aussi de diminuer la bande de pré-détection sans réduire la bande de boucle dimensionnée pour un profil de dynamique spécifié. L'intérêt de réduire la bande de pré-détection est d'augmenter le rapport signal sur bruit au niveau du discriminateur, ce qui est utile dans le cas de l'utilisation de l'arctangente étendu, qui est un élément dimensionnant pour la robustesse au bruit de la boucle. On améliore ainsi le compromis entre robustesse au bruit et robustesse à la dynamique.

Le dispositif selon l'invention permet de compenser ces différents retards. Plus précisément, l'invention a pour objet un dispositif de réception de signaux de radionavigation par satellite, lesdits signaux reçus étant émis à une première fréquence dite fréquence porteuse, ledit dispositif comprenant au moins des moyens permettant de générer un signal local à une seconde fréquence dite fréquence locale et un dispositif de poursuite comportant une boucle de rétroaction dite boucle de porteuse permettant d'asservir en phase la fréquence locale sur la fréquence porteuse, ladite boucle de rétroaction comportant une partie matérielle et une partie logicielle, ladite partie matérielle comportant au moins un intégrateur qui réalise la corrélation entre le signal local et le signal reçu, le signal issu de la corrélation étant appelé signal corrélé, ladite corrélation étant réalisée à haute fréquence, ladite partie logicielle réalisant les fonctions de discrimination de la phase du signal corrélé et le filtrage de la dite phase, la partie logicielle travaillant à basse fréquence, la durée d'un cycle élémentaire de calcul étant noté T, chaque cycle étant indicé d'un nombre entier n de façon que la durée d'un cycle soit compris dans l'intervalle de temps [(n-1)T, nT], le signal corrélé à l'instant nT étant noté Zp(n), le signal θ(n) issu de la discrimination étant égal à l'argument du produit $Z_R(n)$ de Zp(n) par une fonction exponentielle complexe $Z_C(n)$ dont l'argument est un terme de compensation fonction de n et de T, caractérisé en ce que, si on note C(n) le coefficient de variation linéaire de la phase de la fréquence locale $\varphi_{locale}$ entre les instants nT et (n+1)T tel que $[\varphi_{locale}((n+1)T) - (\varphi_{locale}(nT)]/T$ soit égal à C(n), C(n) étant calculé antérieurement à partir des données disponibles respectivement à l'instant (n-1)T concernant la valeur de la phase reçue, sa position et son accélération, alors ce dit terme de compensation dépend au moins de C(n) et de C(n-1). Plus précisément, le terme de compensation est égal à l'opposé de la somme de C(n) et de ½ C(n-1).

Avantageusement, lorsque le signal reçu ne comporte pas de données, on utilise un discriminateur étendu ou enrouleur, le signal θ(n) issu de la discrimination étant égal au signal θ(n-1) augmenté de l'argument pris sur l'intervalle ]-π, +π] du produit des fonctions complexes $Z_R(n)$ et $Z_R(n-1)^*$. Et, lorsque le signal reçu comporte des données, le signal

$\theta(n)$ issu de la discrimination est égal au signal $\theta(n-1)$ augmenté de l'argument pris sur l'intervalle $]-\pi/2, +\pi/2]$ du produit des fonctions complexes $Z_R(n)$ et $Z_R(n-1)^*$.

L'invention concerne également un dispositif de réception de signaux de radionavigation par satellite, lesdits signaux reçus étant émis à une première fréquence dite fréquence porteuse, ledit dispositif comprenant au moins des moyens permettant de générer un signal local à une seconde fréquence dite fréquence locale et un dispositif de poursuite comportant une boucle de rétroaction dite boucle de porteuse permettant d'asservir en phase la fréquence locale sur la fréquence porteuse, ladite boucle de rétroaction comportant une partie matérielle et une partie logicielle, ladite partie matérielle comportant au moins un intégrateur qui réalise la corrélation entre le signal local et le signal reçu, le signal issu du corrélateur étant appelé signal corrélé, ladite corrélation étant réalisée à haute fréquence, ladite partie logicielle réalisant les fonctions de discrimination de la phase du signal corrélé et le filtrage de la dite phase, la partie logicielle travaillant à basse fréquence, la durée d'un cycle élémentaire de calcul étant notée T, chaque cycle étant indicé d'un nombre entier n de façon que la durée d'un cycle soit compris dans l'intervalle de temps $[(n-1)T, nT]$, caractérisé en ce que, ledit intervalle de temps étant découpé en M sous-intervalles de durée T/M, lesdits sous-intervalles étant référencés en m, le signal corrélé à l'instant $(n+m/M).T$ étant noté $Zp(n, m)$, alors la fonction $Zp'(n)$ est égale à la somme des produits de $Zp(n, m)$ par une fonction exponentielle complexe dont l'argument vaut $-C(n-1)+(m-\frac{1}{2}).[C(n)-C(n-1)]/M$ avec $C(n)$ coefficient de variation linéaire entre les phases locales $\varphi_{locale}$ aux instants $nT$ et $(n-1)T$ tel que $C(n)$ soit égale à $[\varphi_{locale}((n+1)T)-\varphi_{locale}(nT)]/T$, le signal $\theta(n)$ issu de la discrimination étant égal à l'argument du produit de $Zp'(n)$ multiplié par une fonction exponentielle complexe $Z_R(n)$ dont l'argument vaut $-1/2.C(n-1)$.

Avantageusement, lorsque la phase reçue se déplace, par effet Doppler, à la vitesse V, le coefficient de variation linéaire C'(n) de la phase locale est égal à $C(n) + [\delta(n+1) - \delta(n)]$ avec $C(n)$ égal à $[P(n) - P(n-1)]/T$ et $\delta(n+1)$ égal à $3/2.V(n).T$, et le discriminateur $\theta'(n)$ est égal à $\theta(n) + \frac{1}{2} [\delta(n-1) + \delta(n-2)]$, en notant $P(n)$ la valeur de la phase et $V(n)$ la vitesse de variation de la phase à l'instant $nT$.

Enfin, lorsque la phase reçue se déplace, par effet Doppler, à la vitesse V avec l'accélération A, le coefficient de variation linéaire C'(n) de la phase locale est égal à $C(n) + [\delta(n+1) - \delta(n)]$ avec $C(n)$ égal à $[P(n) - P(n-1)]/T$ et $\delta(n+1)$ égal à $3/2.[V(n) +2.A(n).T].T$, et le discriminateur $\theta'(n)$ est égal à $\theta(n) + \frac{1}{2} [\delta(n-1) + \delta(n-2)]$, en notant $A(n)$ l'accélération de la phase reçue à l'instant $nT$.

L'invention sera mieux comprise et d'autres avantages apparaîtront à la lecture de la description qui va suivre donnée à titre non limitatif et grâce aux figures annexées parmi lesquelles :

- La figure 1 représente le signal reçu, sa fonction d'autocorrélation et sa transformée de Fourier ;
- La figure 2 représente le synoptique général des dispositifs de poursuite d'un récepteur de signaux satellitaires ;
- La figure 3 représente le synoptique général d'une boucle de rétroaction dite boucle de porteuse ;
- La figure 4 représente les variations des différentes phases reçues en fonction du temps dans un premier dispositif de réception selon l'art antérieur ;
- La figure 5 représente les variations des différentes phases reçues en fonction du temps dans un second dispositif de réception selon l'art antérieur ;
- La figure 6 représente les principaux paramètres représentatifs des variations des phases reçues et locales en fonction du temps dans les dispositifs de réception selon l'invention ;
- La figure 7 représente les variations des différentes phases reçues en fonction du temps dans un premier mode de réalisation d'un dispositif de réception selon l'invention ;
- Les figures 8 et 9 représentent les paramètres Zp(n) et Zc(n) dans un plan complexe ;
- Les figures 10 et 11 représente les évolutions du discriminateur en fonction de l'écart de phase ;

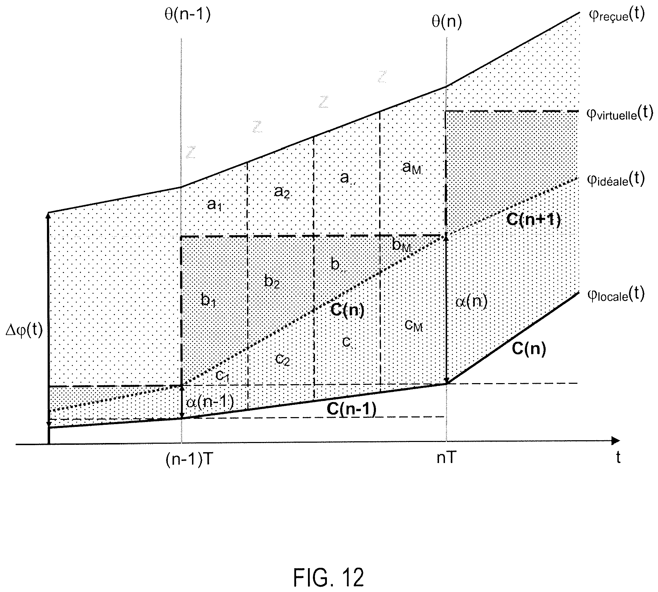

- La figure 12 représente les variations des différentes phases reçues en fonction du temps dans un second mode de réalisation d'un dispositif de réception selon l'invention ;
- La figure 13 représente les variations des différentes phases reçues en fonction du temps dans un troisième mode de réalisation d'un dispositif de réception selon l'invention.

Un dispositif selon l'invention comprend classiquement une partie matérielle et une partie logicielle. Seule la partie logicielle est nouvelle. Ainsi, il est possible de bénéficier des avantages du dispositif sans modifier la partie matérielle.

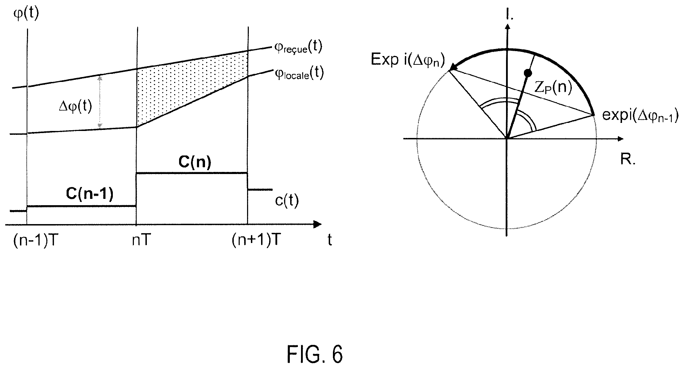

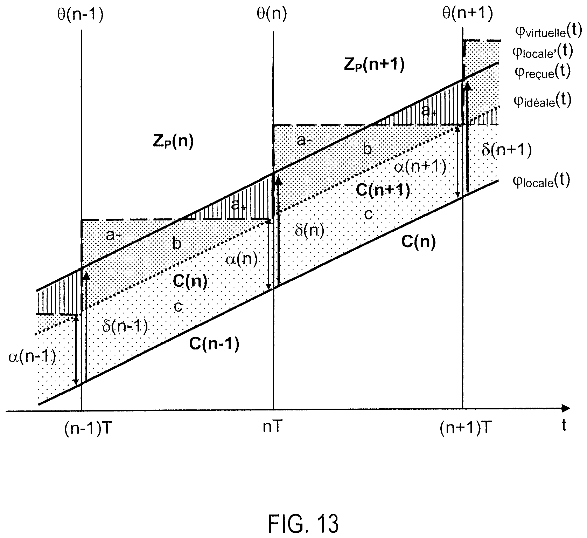

Dans les graphes des figures 6, 7, 8, 13 et 14 qui représentent les variations des différentes phases en fonction du temps, les variations de la phase de la porteuse locale dues à la partie matérielle sont modélisées sous forme de lignes continues, car la fréquence de travail de la partie matérielle, comprise entre 1 et 100 MHz, est très élevée par rapport à celle du logiciel qui est d'environ 50 Hz. L'échelle des temps est découpée en intervalles de temps discrets nT, n étant un entier, chaque intervalle de temps T correspondant à une tâche du logiciel. T vaut couramment 20 ms.

Soit une variation linéaire de la variation de phase $\Delta\varphi(t)$ sur l'intervalle d'intégration $[(n-1)T, nT]$, cette hypothèse est toujours vraie pour $\varphi_{locale}(t)$, compte-tenu du bloqueur d'ordre 0 et du NCO, on peut écrire alors, avec les mêmes notations que précédemment :

$$\varphi_{locale}(t) = \varphi_{locale}(t_0) + \int_{[t0,\,t]} c(\tau)\,d\tau,$$

soit :

$$\varphi_{locale}(nT) = \varphi_{locale}((n-1)T) + T.C(n-1)$$

soit encore :

$$\varphi_{locale}((n+1)T) = \varphi_{locale}(nT) + T.C(n)$$

Par abus de langage, on écrira indifféremment :

$$\varphi(nT) = \varphi(n) = \varphi_n$$

Le signal issu de l'intégrateur vaut :

$$Z_P(n) = \int_{[(n-1)T,\,nT]} A.expi(\varphi_{reçue}(t)).expi(-\varphi_{locale}(t)).dt$$

$$Z_P(n) = \int_{[(n-1)T,\,nT]} A.expi(\varphi_{reçue}(t) - \varphi_{locale}(t)).dt$$

$$Z_P(n) = \int_{[(n-1)T,\,nT]} A.expi(\Delta\varphi(t)).dt$$

avec

$$\Delta\varphi(t) = \varphi_{reçue}(t) - \varphi_{locale}(t)$$

Ces différents paramètres sont représentés graphiquement sur la figure 6. Celle-ci comporte deux représentations : à gauche, les variations de la phase en fonction du temps et à droite la représentation des variations de phase et du signal $Z_P(n)$ dans le plan complexe (R, I), R représentant la partie réelle et I la partie imaginaire.

On montre, par le calcul, que, moyennant l'hypothèse d'une variation linéaire de $\Delta\varphi(t)$ sur l'intervalle d'intégration $[(n-1)T, nT]$, on a alors :

$$Z_P(n) = A.T.expi(\tfrac{1}{2}[\Delta\varphi(n) + \Delta\varphi(n-1)]).sinc(\tfrac{1}{2}[\Delta\varphi(n) - \Delta\varphi(n-1)])$$

Les termes expi et sinc représentent les abréviations classiques de l'exponentielle complexe et du sinus cardinal.

L'argument de $Z_P(n)$ est celui du facteur $expi(\tfrac{1}{2}[\Delta\varphi(n) + \Delta\varphi(n-1)])$. On détermine ainsi le terme $\tfrac{1}{2}[\Delta\varphi(n) + \Delta\varphi(n-1)]$ qui est la moyenne de l'écart entre la phase reçue et la phase locale sur l'intervalle d'intégration. L'argument de $Z_P(n)$ est représenté sur les différentes figures représentant les variations de phase par une aire grisée.

Le facteur réel $sine(\tfrac{1}{2}[\Delta\varphi(n) - \Delta\varphi(n-1)])$ qui disparaît dans l'argument constitue la perte Doppler, qui réduit l'amplitude du signal après l'intégration cohérente, ce qui peut être néfaste pour la robustesse au bruit.

On pose :

$$\theta(n) = arg(Z_P(n)),$$

soit :

$$\theta(n) = \tfrac{1}{2} \left[ \Delta\varphi_n + \Delta\varphi_{n-1} \right]$$

$$\theta(n) = \tfrac{1}{2} \left[ \varphi_{\text{reçue}}(nT) + \varphi_{\text{reçue}}((n-1)T) \right] - \tfrac{1}{2} \left[ \varphi_{\text{locale}}(nT) + \varphi_{\text{locale}}((n-1)T) \right]$$

Le correcteur de boucle est réalisé par les 3 étapes suivantes à partir de l'instant nT :

$$A(n+1) = A(n) \qquad\qquad + T.K3.\theta(n)$$

$$V(n+1) = V(n) + T.A(n) + T.K2.\theta(n)$$

$$P(n+1) = P(n) + T.V(n) + T.K1.\theta(n)$$

Avec A(n), V(n), P(n) représentant respectivement une estimée de l'accélération, la vitesse et la position de la phase.

La commande de compensation peut être appliquée soit sans retard, soit avec retard.
Dans le premier cas, on applique la commande sur l'intervalle d'intégration [nT, (n+1)T ], on a :

$$C(n) = \left[ P(n+1) - P(n) \right]/T = V(n) + K1.\theta(n)$$

$$C(n) = \left[ \varphi_{\text{locale idéale}}((n+1)T) - \varphi_{\text{locale idéale}}(nT) \right]/T$$

$$C(n) = \left[ \varphi_{\text{locale}} \quad ((n+1)T) - \varphi_{\text{locale}} \quad (nT) \right]/T$$

$$P(n) = \varphi_{\text{locale idéale}}(nT) = \varphi_{\text{locale}}(nT)$$

Dans le second cas, on applique la commande sur l'intervalle d'intégration [(n+1)T, (n+2)T] et on a :

$$C(n+1) = \left[ P(n+1) - P(n) \right]/T = V(n) + K1.\theta(n)$$

$$C(n+1) = \left[ \varphi_{\text{locale idéale}}((n+1)T) - \varphi_{\text{locale idéale}}(nT) \right]/T$$

$$C(n+1) = \left[ \varphi_{\text{locale}} \quad ((n+2)T) - \varphi_{\text{locale}} \quad ((n+1)T) \right]/T$$

$$P(n) = \varphi_{\text{locale idéale}}(nT) = \varphi_{\text{locale}}((n+1)T)$$

En représentations d'état, le correcteur de boucle peut être représenté de la façon suivante :

Entrée du système :

$$E(n) = \varphi_{\text{reçue}}(nT)$$

Etats initiaux du correcteur de boucle au temps nT : A(n), V(n) et P(n) représentant respectivement l'accélération, la vitesse et la position.

Sortie du correcteur :

$$P(n) = \varphi_{locale}((n+1)T)$$

Comparateur :

$$\theta(n) = \tfrac{1}{2}\,[E(n) + E(n-1)] - \tfrac{1}{2}\,[P(n-1) + P(n-2)]$$

Correcteur de boucle :

$$A(n+1) = A(n) + \qquad T.K3.\theta(n)$$

$$V(n+1) = V(n) + T.A(n) + T.K2.\theta(n)$$

$$P(n+1) = P(n) + T.V(n) + T.K1.\theta(n)$$

Le comparateur $\theta(n)$ fournit une mesure de l'écart entre la phase reçue moyenne $\tfrac{1}{2}\,[E(n) + E(n-1)]$ et la dernière phase locale moyenne en retard $\tfrac{1}{2}\,[P(n-1) + P(n-2)]$. Idéalement il faudrait pour ne pas avoir de retard que la condition suivante soit remplie :

$$\theta(n) = \tfrac{1}{2}\,[E(n) + E(n-1)] - P(n)$$

$$\theta(n) = \tfrac{1}{2}\,[\varphi_{reçue}(nT) + \varphi_{reçue}((n-1)T)] - \varphi_{locale}((n+1)T)$$

$$\theta(n) = \tfrac{1}{2}\,[\varphi_{reçue}(nT) + \varphi_{reçue}((n-1)T)] - \varphi_{idéale}(nT)$$

On retrouve ainsi les 2 retards qui sont :

Retard de NCO :

$$P(n) - \tfrac{1}{2}\,[P(n) + P(n-1)]$$

Retard de calcul :

$$\tfrac{1}{2}\,[P(n) + P(n-1)] - \tfrac{1}{2}\,[P(n-1) + P(n-2)]$$

Le coeur du dispositif selon l'invention est de corriger le discriminateur de telle sorte que l'on compense au mieux les retards. On montre que la correction à apporter dépend uniquement des commandes actuelles ou anciennes qui sont parfaitement connues. Le dispositif ne corrige pas le retard sur la phase locale en sortie du NCO, mais cela rend le comportement en boucle fermée beaucoup plus stable, y compris avec des bandes de boucle plus grandes. Le retard sur la phase locale en sortie du NCO, proportionnel au Doppler, peut néanmoins être corrigé par anticipation.

Dans la solution de base du dispositif selon l'invention, la compensation des retards est effectuée dans le discriminateur. Outre la phase reçue et la phase locale produite par le NCO, on considère deux phases imaginaires :

- la phase idéale, qui est la phase locale que l'on obtiendrait sans retard d'application de la commande ;
- La phase virtuelle, qui est la phase locale que l'on obtiendrait sans retard d'application de la commande avec un recalage instantané en saut, et non plus en vitesse.

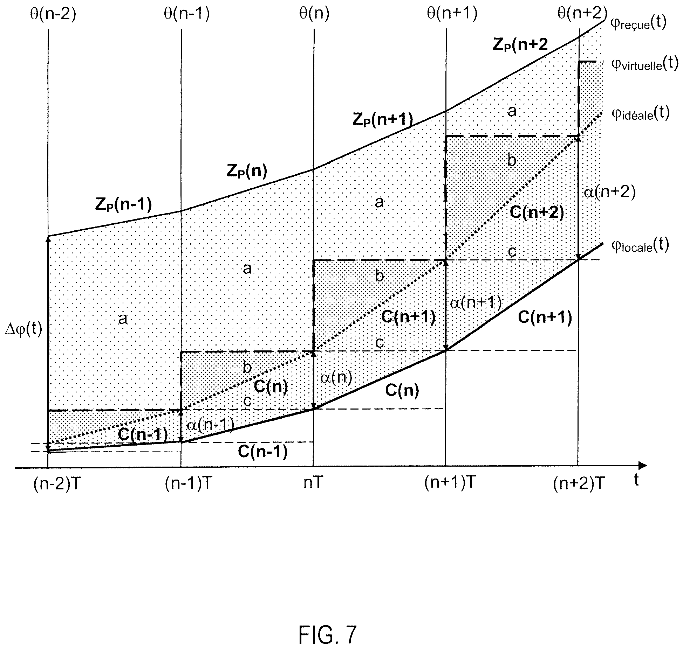

Ces différentes phases sont représentées en figure 7.
On a :

$$Z_P(n) = \int_{[(n-1)T,\, nT]} A.\text{expi}(\varphi_{\text{reçue}}(t) - \varphi_{\text{locale}}(t)).dt$$

Soit encore :

$$Z_P(n) = A.T.\text{expi}(\tfrac{1}{2}[\Delta\varphi(n) + \Delta\varphi(n-1)]).\text{sinc}(\tfrac{1}{2}[\Delta\varphi(n) - \Delta\varphi(n-1)])$$

Avec

$$\Delta\varphi(n) = \varphi_{\text{reçue}}(n-1) - \varphi_{\text{locale}}(n)$$

On veut que :

$$\theta(n) = \tfrac{1}{2}[\varphi_{\text{reçue}}(n-1) + \varphi_{\text{reçue}}(n)] - \varphi_{\text{idéale}}(n)$$

On note « a » cette valeur comme représenté en figure 7.
On a déjà :

$$\arg(Z_P(n)) = \tfrac{1}{2}[\varphi_{\text{reçue}}(n-1) + \varphi_{\text{reçue}}(n)] - \tfrac{1}{2}[\varphi_{\text{locale}}(n-1) + \varphi_{\text{locale}}(n)]$$

$$\arg(Z_P(n)) = a + b + c$$

$$a = \tfrac{1}{2}[\varphi_{\text{reçue}}(n-1) + \varphi_{\text{reçue}}(n)] - \varphi_{\text{idéale}}(n)$$

$$b = \tfrac{1}{2}[\varphi_{\text{idéale}}(n) - \varphi_{\text{idéale}}(n-1)]$$

$$c = \tfrac{1}{2}[\varphi_{\text{idéale}}(n) + \varphi_{\text{idéale}}(n-1)] - \tfrac{1}{2}[\varphi_{\text{locale}}(n-1) + \varphi_{\text{locale}}(n)]$$

$$b = \tfrac{1}{2}[\varphi_{\text{locale}}(n+1) - \varphi_{\text{locale}}(n)]$$

$$c = \tfrac{1}{2}[\varphi_{\text{idéale}}(n-1) - \varphi_{\text{locale}}(n-1)] + \tfrac{1}{2}[\varphi_{\text{idéale}}(n) - \varphi_{\text{locale}}(n)]$$

Soit :

$$\theta(n) = \arg(Z_P(n)) - b - c$$

On cherche à exprimer b et c en fonction des précédentes commandes du correcteur de boucle :

$$b = \tfrac{1}{2}C(n)$$

Soit

$$\alpha(n) = \varphi_{\text{idéale}}(n) \; - \; \varphi_{\text{locale}}(n)$$

$$c = \tfrac{1}{2}[\alpha(n\text{-}1) + \alpha(n)]$$

$\alpha(n)$ est construit par récurrence :

$$\alpha(n) = \alpha(n\text{-}1) + C(n) - C(n\text{-}1)$$

Si $\alpha(0) = 0$, $C(0) = 0$, $C(1) = 0$ alors $\alpha(n) = C(n)$ pour tout n
Donc

$$c = \tfrac{1}{2}[C(n\text{-}1) + C(n)]$$

$$\theta(n) = \arg(\, Z_P(n)\,) - C(n) - \tfrac{1}{2}\,C(n\text{-}1)$$

$$\theta(n) = \arg(\, Z_P(n)\,) - \text{Compensation}(n)$$

Avec Compensation$(n) = C(n) + \tfrac{1}{2}\,C(n\text{-}1)$

En pratique, lorsque l'on extrait l'argument de $Z_P(n)$ il faut d'abord décider dans quel intervalle on veut se placer : $]\Delta\text{-}\pi,\Delta\text{+}\pi]$. Cet intervalle doit être centré autour de la valeur $\Delta$ la plus probable de Arg$(\, Z_P(n)\,)$, afin de minimiser le risque de basculer de l'autre côté à cause du bruit ou de la dynamique. Un basculement induit une erreur de $2\pi$.

Il se trouve que la valeur la plus probable de Arg$(\, Z_P(n)\,)$, sachant les commandes NCO déjà appliquée, est Compensation$(n)$.

Il suffit donc de faire :

$$Z_C(n) \; = \; \text{expi}(\, \text{Compensation}(n)\,)$$

$$Z_R(n) \; = \; Z_P(\, n\,) \, . \, Z_C(\, n\,)^*$$

Si on n'a pas de donnée (voie pilote) :

$$\theta(n) \; = \; \arg_{]\text{-}\pi,\pi]}\, (\, Z_R(n)\,) = \arg_{]\text{-}\pi,\pi]}\, [\, Z_P(n)\, . \, \text{expi}(-\, C(n) - \tfrac{1}{2}\,C(n\text{-}1)\,)\,]$$

Si on a des données :

$$\theta(n) \; = \; \arg_{]\text{-}\pi/2,\pi/2]}(\, Z_R(n)\,) = \arg_{]\text{-}\pi/2,\pi/2]}[\, Z_P(n)\, . \, \text{expi}(-\, C(n) - \tfrac{1}{2}\,C(n\text{-}1)\,)\,]$$

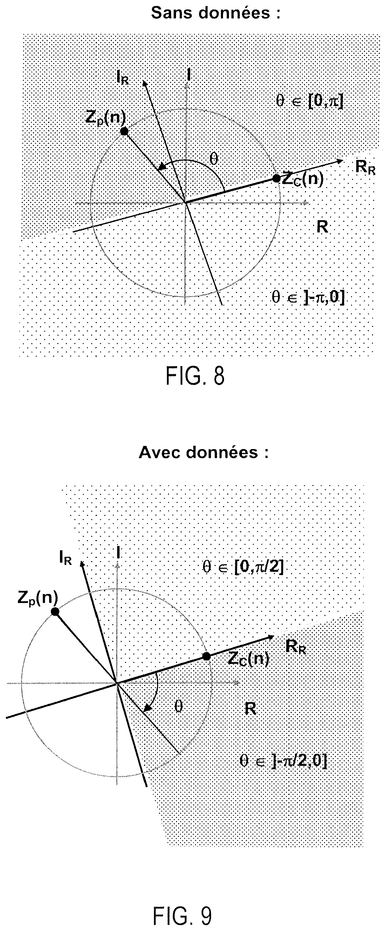

Ces deux cas de figures sont illustrés en figures 8 et 9 où les signaux $Z_P(n)$ et $Z_C(n)$ sont représentés dans le plan complexe (R, I).

Si le système doit tolérer une erreur de phase plus importante due, par exemple, au traînage en présence de dynamique et supérieure à l'intervalle $]\text{-}\pi,\pi]$, on utilise un discriminateur permettant de tolérer une erreur plus importante de la boucle. Il consiste à compter le nombre de tours et fournit un angle $\theta$ hors de l'intervalle $]\text{-}\pi,+\pi]$: On appelle ce discriminateur « discriminateur enrouleur » ou « discriminateur étendu ». On a

$$Z_R(n-1) = Z_P(n-1).Z_C(n-1)^*$$

et

$$Z_R(n) = Z_P(n).Z_C(n)^*$$

Dans ce cas, en présence de données, on a :

$$\theta(n) = \arg{}_{]-\pi,\pi]}(Z_R(n).Z_R(n-1)^*) + \theta(n-1)$$

En l'absence de données, on a :

$$\theta(n) = \arg{}_{]-\pi/2,\pi/2]}(Z_R(n).Z_R(n-1)^*) + \theta(n-1)$$

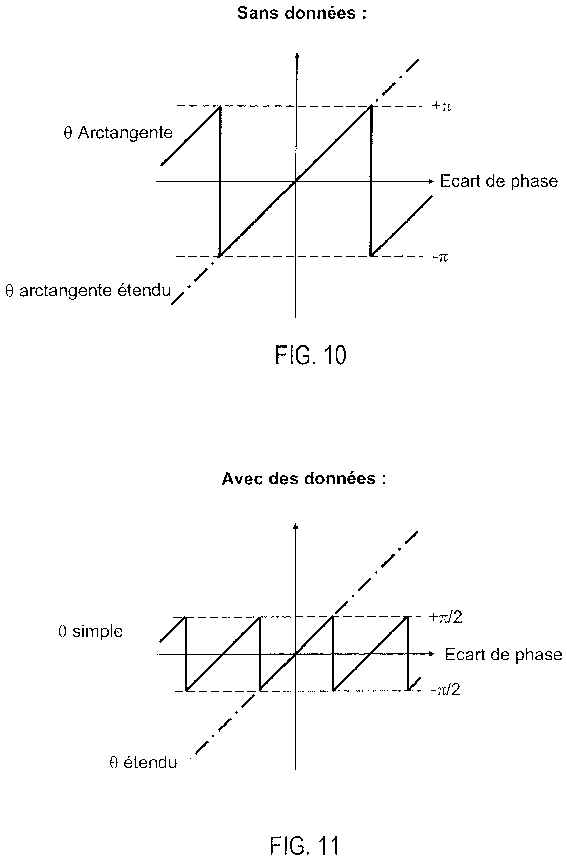

Les figures 10 et 11 représentent en traits pleins les variations de $\theta(n)$ en fonction de l'écart de phase lorsque l'on les calcule à partir de la valeur de l'argument, variations notées $\theta$ simple et en traits pointillés les variations de $\theta(n)$ lorsque l'on les calcule à partir de la valeur de l'argument mais en tenant compte des valeurs précédentes, variations notées $\theta$ étendu.

Ce discriminateur permet d'augmenter la robustesse à la dynamique sans changer la bande de boucle ni la bande de pré-détection. Il n'introduit pas de charges supplémentaires au niveau du logiciel. Par contre, il réduit la robustesse au bruit. Des sauts de cycles ou des décrochages de la boucle deviennent possibles.

Il est possible d'améliorer encore le discriminateur selon l'invention. Une première amélioration consiste à compenser les pertes Doppler. La correction apportée sur le discriminateur permet de compenser le retard à l'intérieur de la boucle du point de vue du comportement dynamique. Cependant, la phase locale n'est pas affectée. La fréquence de la porteuse locale reste en retard par rapport à la porteuse reçue, ce qui peut augmenter les pertes Doppler en présence de forte accélération où le facteur sinc($\frac{1}{2}\Delta\varphi(n) - \frac{1}{2}\Delta\varphi(n-1)$) devient petit à cause de $\frac{1}{2}\Delta\varphi(n) - \frac{1}{2}\Delta\varphi(n-1)$ contenant $\Delta\varphi C(n) - \frac{1}{2}C(n-1)$ qui devient grand.. Afin de limiter les pertes Doppler, on découpe l'intervalle $[(n-1)T, nT]$ en M sous intervalles de longueur T/M et on réalise M intégrations élémentaires $Z_P(n,m)$ pour m égal à 1,2, .. , M

On a alors :

$$Z_P(n) = \Sigma_{m=1,2,..M} Z_P(n,m)$$

Avec

$$Z_P(n,m) = \int_{[(n-1)T+(m-1)T/M,\ (n-1)T+mT/M]} \exp i(\varphi_{reçue}(t) - \varphi_{locale}(t)).dt$$

Soit encore :

$$Z_P(n,m) = A.T/M.\exp i(\tfrac{1}{2}[\Delta\varphi(n-1,m) + \Delta\varphi(n-1,m-1)]).\text{sinc}(\tfrac{1}{2}[\Delta\varphi(n-1,m) - \Delta\varphi(n-1,m-1)])$$

On retrouve l'expression en exponentielle complexe et sinus cardinal avec :

$$\Delta\varphi(n,m) = \Delta\varphi(nT + m.T/M) = \varphi_{reçue}(n,m) - \varphi_{locale}(n,m)$$

et

$$\arg(Z_P(n,m)) = \tfrac{1}{2}[\Delta\varphi(n-1,m) + \Delta\varphi(n-1,m-1)]$$

$$\arg(Z_P(n,m)) = \tfrac{1}{2}[\varphi_{reçue}(n-1,m) + \varphi_{reçue}(n-1,m-1)] - \tfrac{1}{2}[\varphi_{locale}(n-1,m-1) + \varphi_{locale}(n-1,m)]$$

On décompose $\arg(Z_P(n,m))$ en trois termes :

$$\arg(Z_P(n,m)) = a_m + b_m + c_m$$

avec

$$a_m = \tfrac{1}{2}[\varphi_{reçue}(n-1,m) + \varphi_{reçue}(n-1,m-1)] - \varphi_{virtuelle}(n-1,m)$$

$$b_m = \varphi_{virtuelle}(n-1,m) - \tfrac{1}{2}[\varphi_{idéale}(n-1,m) + \varphi_{idéale}(n-1,m-1)]$$

$$c_m = \tfrac{1}{2}[\varphi_{idéale}(n-1,m) + \varphi_{idéale}(n-1,m-1)] - \tfrac{1}{2}[\varphi_{locale}(n-1,m-1) + \varphi_{locale}(n-1,m)]$$

Et on peut écrire :

$$Z_P(n,m) = A.T/M.\ expi(a_m + b_m + c_m)\ .\ sinc(\Delta)$$

avec

$$sinc(\Delta) = sinc(\tfrac{1}{2}[\Delta\varphi(n-1,m) - \Delta\varphi(n-1,m-1)])$$

Cette expression est indépendante de m dans la mesure où les variations de $\Delta\varphi$ sont linéaires.

On corrige, comme précédemment, chaque $Z_P(n,m)$ de la quantité $c_m$ et on intègre. On obtient :

$$Z_P'(n) = \Sigma_{m=1,2,..M} Z_P(n,m)\ .\ expi(-c_m)$$

$$Z_P'(n) = \Sigma_{m=1,2,..M} A.T/M.\ expi(a_m + b_m)\ .\ sinc(\Delta)$$

On calcule $Z_P'(n)$, en supposant une variation linéaire sur l'intervalle $[(n-1)T, nT]$ :

$$Z_P'(n) = A.T.expi(\tfrac{1}{2}[(a_1+b_1) + (a_M+b_M)])\ .\ sinc_M(\tfrac{1}{2}[(a_1+b_1) - (a_M+b_M)]).sinc(\Delta)$$

avec

$$sinc_M(x) = sin(x.(M+1)/M)/sin(x/M)/M \cong sinc(x)$$

si M est grand

$$sinc_M(\tfrac{1}{2}[(a_1+b_1) - (a_M+b_M)]) \cong sinc(\tfrac{1}{2}[\Delta'\varphi(n) - \Delta'\varphi(n-1)])$$

si M est grand et

$$\text{expi}(\ \tfrac{1}{2}\ [(a_1+b_1) + (a_M+b_M)]) = \text{expi}(\ \tfrac{1}{2}\ [\Delta'\varphi(n) + \Delta'\varphi(n\text{-}1)])$$

Avec

$$\Delta'\varphi(n) = \varphi_{\text{reçue}}(n) - \varphi_{\text{idéale}}(n)$$

D'où

$$Z_P'(n) = A.T.\text{expi}(\ \tfrac{1}{2}[\Delta'\varphi(n) + \Delta'\varphi(n\text{-}1)]) \ . \ \text{sinc}(\ \tfrac{1}{2}[\Delta'\varphi(n) - \Delta'\varphi(n\text{-}1)]) \ . \ \text{sinc}(\Delta)$$

On retrouve les deux facteurs de l'expression de $Z_P(n)$ vue précédemment, à la différence près que la perte Doppler représentée par le facteur en sinus cardinal n'est plus entre la phase reçue et la phase locale, mais entre la phase reçue et la phase idéale sans retard. Elle est donc moins importante. Le facteur $\text{sinc}(\Delta)$ représente également une perte Doppler entre la phase reçue et la phase locale, mais sur une durée moindre, donc beaucoup moins sensible que lorsque l'on fait une correction globale. On a donc :

$$\arg(Z_P'(n)) = \tfrac{1}{2}\ [\varphi_{\text{reçue}}(n\text{-}1) + \varphi_{\text{reçue}}(n)] - \tfrac{1}{2}\ [\varphi_{\text{idéale}}(n\text{-}1) + \varphi_{\text{idéale}}(n)]$$

ou encore :

$$\arg(Z_P'(n)) = a + b$$

On veut, comme précédemment :

$$\theta(n) = a$$

Il ne reste plus qu'à corriger de la quantité b :

$$\theta(n) = \arg(Z_P'(n)) - b$$

$$\theta(n) = \arg(Z_P'(n)) - \tfrac{1}{2}\ C(n)$$

Ou encore :

$$\theta(n) = \arg[Z_P'(n) \ . \ \text{expi}(\ - \tfrac{1}{2}\ C(n))]$$

On calcule les termes $c_m$. On peut poser, en prenant l'hypothèse d'une variation linéaire de $\alpha(n)$ à $\alpha(n\text{-}1)$ sur l'intervalle $[(n\text{-}1)T, nT])$ :

$$c_m = \alpha(n\text{-}1) + (m - \tfrac{1}{2}).\beta(n\text{-}1)$$

$$\text{avec } \alpha(n\text{-}1) = C(n\text{-}1) \text{ et } \beta(n\text{-}1) = [\alpha(n) - \alpha(n\text{-}1)] / M$$

Pour M grand, on peut écrire :

$$Z_P(n,m) = \int_{[(n-1)T+(m-1)T/M, (n-1)T+mT/M]} \mathrm{expi}(\varphi_{reçue}(t) - \varphi_{locale}(t)).dt$$

$$Z_P(n,m) \cong A.T/M . \mathrm{expi}(\varphi_{reçue}(t_m) - \varphi_{locale}(t_m))$$

Avec

$$t_m = (n-1)T+(m-\tfrac{1}{2})T/M,$$

$$Z_P'(n) = \Sigma_{m=1, 2, .. M} Z_P(n,m) . \mathrm{expi}( - c_m)$$

$$Z_P'(n) \cong \Sigma_{m=1, 2, ..M} A.T/M.\mathrm{expi}(\varphi_{reçue}(t_m) - \varphi_{locale}(t_m)).\mathrm{expi}(-\varphi_{idéale}(t_m) + \varphi_{locale}(t_m))$$

$$Z_P'(n) \cong \int_{[(n-1)T, nT]} A.\mathrm{expi}(\varphi_{reçue}(t) - \varphi_{idéale}(t)).dt$$

On retrouve l'expression de $Z_P(n)$ si on remplace $\varphi_{idéale}(t)$ par $\varphi_{locale}(t_m)$. Tout se passe comme s'il n'y avait pas de retard dans l'application de la commande NCO

On a donc, en final, les expressions suivantes :

$$Z_P(n,m) = \int_{[(n-1)T+(m-1)T/M, (n-1)T+mT/M]} \mathrm{expi}( \varphi_{reçue}(t) - \varphi_{locale}(t) ).dt$$

$$\alpha(n-1) = C(n-1)$$

$$\beta(n-1) = [ C(n) - C(n-1) ] / M$$

et

$$Z_P'(n) = \Sigma_{m=1, 2, .. M} Z_P(n,m) . \mathrm{expi}( - \alpha(n-1) + (m - \tfrac{1}{2} ) . \beta(n-1))$$

$$\theta(n) = \mathrm{Arg}[Z_P'(n) . \mathrm{expi}( - \tfrac{1}{2} C(n))]$$

La réalisation pratique ne pose aucun problème technique particulier. Les $Z_P(n,m)$ pour m = 1, 2, .., M sont produits par la partie matérielle et fournis au logiciel par paquets à chaque fin d'intervalle de temps $[(n-1)T, nT]$. Le calcul de $Z_P'(n)$ est effectué par le logiciel.

A titre d'exemple, on peut prendre comme valeurs significatives :

T = 20 ms
M = 20,
soit T/M = 1 ms

Il existe une deuxième voie d'amélioration possible qui consiste à anticiper les retards sur la phase locale. La correction appliquée sur le discriminateur ne change pas le retard sur la phase locale. Cependant il est possible de compenser par anticipation ce retard qui vaut $\delta = 3/2.V.T$ en présence de Doppler V.

On applique au NCO la commande C'(n) au lieu de C(n) sur l'intervalle [nT, (n+1)T] avec :

$$C'(n) = C(n) + \delta(n+1) - \delta(n)$$

Cette commande est calculée à partir des données disponibles à l'instant (n-1)T :

$$A(n) = A(n-1) + \quad T.K3 . \theta'(n-1)$$

$$V(n) = V(n-1) + T.A(n-1) + T.K2 . \theta'(n-1)$$

$$P(n) = P(n-1) + T.V(n-1) + T.K1 . \theta'(n-1)$$

D'où :

$$C(n) = [ P(n) - P(n-1) ] / T$$

$$\delta(n) = 3/2.V(n-1).T$$

$$\delta(n+1) = 3/2.V(n).T$$

Afin de ne pas perturber le comportement de la boucle, on corrige le discriminateur en cohérence :

$$\theta'(n) = \theta(n) + \tfrac{1}{2} [ \delta(n-1) + \delta(n-2) ]$$

Cette compensation du retard sur la phase locale fonctionne parfaitement en régime permanent à vitesse (Doppler) constante. En régime permanent à accélération constante on peut anticiper la variation de la vitesse V entre le milieu de l'intervalle [(n-2)T, (n-1)T] et le milieu de l'intervalle [nT, (n+1)T] :

$$\delta(n) = 3/2 [V(n-1) + 2.A(n-1).T].T$$

$$\delta(n+1) = 3/2 [V(n) + 2.A(n).T ].T$$

Par exemple, dans le cas d'un signal sans données correspondant à la voie pilote, avec une bande de pré-détection de 50 Hz correspondant à une période T de 20 millisecondes, et des gains K1, K2, K3 optimisés pour la tenue à un échelon d'accélération, le dispositif tolère un saut instantané d'accélération de 24 g, contre 4 g pour une boucle traditionnelle.

**Revendications**

1. Dispositif de réception de signaux (S) de radionavigation par satellite, lesdits signaux reçus étant émis à une première fréquence dite fréquence porteuse, ledit dispositif comprenant au moins des moyens permettant de générer un signal local à une seconde fréquence dite fréquence locale et un dispositif de poursuite comportant une boucle de rétroaction dite boucle de porteuse permettant d'asservir en phase la fréquence locale sur la fréquence porteuse, ladite boucle de rétroaction comportant une partie matérielle (Co, $I_{COR}$, Bo, NCO, PL) et une partie logicielle ($D_P$, $C_P$), ladite partie matérielle comportant au moins un intégrateur ($I_{COR}$) qui réalise la corrélation entre le signal local et le signal reçu, le signal issu de la corrélation étant appelé signal corrélé, ladite corrélation étant réalisée à haute fréquence, ladite partie logicielle réalisant les fonctions de discrimination ($D_P$) de la phase du signal corrélé et le filtrage de la dite phase, la partie logicielle travaillant à basse fréquence, la durée d'un cycle élémentaire de calcul étant noté T, chaque cycle étant indicé d'un nombre entier n de façon que la durée d'un cycle soit compris dans l'intervalle de temps [(n-1)T, nT], le signal corrélé à l'instant nT étant noté Zp(n), le signal $\theta$(n) issu de la discrimination étant égal à l'argument du produit de Zp(n) multiplié par une fonction exponentielle complexe $Z_R$(n) dont l'argument est un terme de compensation fonction de n et de T,

**caractérisé en ce que**, si on note C(n) le coefficient de variation linéaire de la phase de la fréquence locale $\varphi_{locale}$ entre les instants nT et (n+1)T tel que $\varphi_{locale}$((n+1)T) = $\varphi_{locale}$(nT) + T.C(n), C(n) étant calculé antérieurement à partir des données disponibles respectivement à l'instant (n-1)T, alors ce dit terme de compensation est égal à l'opposé de la somme de C(n) et de ½ C(n-1).

2. Dispositif de réception de signaux de radionavigation par satellite selon la revendication 1, **caractérisé en ce que**, lorsque le signal reçu ne comporte pas de données, le signal $\theta$(n) issu de la discrimination est égal au signal $\theta$(n-1) augmenté de l'argument pris sur l'intervalle ]-$\pi$, +$\pi$] du produit des fonctions complexes $Z_R$(n) et $Z_R$(n-1)*.

3. Dispositif de réception de signaux de radionavigation par satellite selon la revendication 1, **caractérisé en ce que**, lorsque le signal reçu comporte des données, le signal $\theta$(n) issu de la discrimination est égal au signal $\theta$(n-1) augmenté de l'argument pris sur l'intervalle ]-$\pi$/2, +$\pi$/2] du produit des fonctions complexes $Z_R$(n) et $Z_R$(n-1)*.

4. Dispositif de réception de signaux (S) de radionavigation par satellite, lesdits signaux reçus étant émis à une première fréquence dite fréquence porteuse, ledit dispositif comprenant au moins des moyens permettant de générer un signal local à une seconde fréquence dite fréquence locale et un dispositif de poursuite comportant une boucle de rétroaction dite boucle de porteuse permettant d'asservir en phase la fréquence locale sur la fréquence porteuse, ladite boucle de rétroaction comportant une partie matérielle (Co, $I_{COR}$, Bo, NCO, PL) et une partie logicielle ($D_P$, $C_P$), ladite partie matérielle comportant au moins un intégrateur ($I_{COR}$) qui réalise la corrélation entre le signal local et le signal reçu, le signal issu de la corrélation étant appelé signal corrélé, ladite corrélation étant réalisée à haute fréquence, ladite partie logicielle réalisant les fonctions de discrimination ($D_P$) de la phase du signal corrélé et le filtrage de la dite phase, la partie logicielle travaillant à basse fréquence, la durée d'un cycle élémentaire de calcul étant notée T, chaque cycle étant indicé d'un nombre entier n de façon que la durée d'un cycle soit comprise dans l'intervalle de temps [(n-1)T, nT],

**caractérisé en ce que**, ledit intervalle de temps étant découpé en M sous-intervalles de durée T/M, lesdits sous-intervalles étant référencés en m, le signal corrélé à l'instant (n+m/M).T étant noté Zp(n, m), alors la fonction Zp'(n) est égale à la somme des produits de Zp(n, m) par une fonction exponentielle complexe dont l'argument vaut -C(n-1)+(m-½).[C(n)-C(n-1)]/M avec C(n) coefficient de variation linéaire de la phase de la fréquence locale $\varphi_{locale}$ entre les instants nT et (n+1)T tel que [$\varphi_{locale}$((n+1)T)-$\varphi_{locale}$(nT)]/T soit égale à C(n), C(n) étant calculé antérieurement à partir des données disponibles à l'instant (n-1)T, le signal $\theta$(n) issu de la discrimination étant égal à l'argument du produit de Zp'(n) multiplié par une fonction exponentielle complexe $Z_R$(n) dont l'argument vaut -1/2.C(n).

5. Dispositif de réception de signaux de radionavigation par satellite selon l'une des revendications 1 à 3, **caractérisé en ce que**, lorsque la phase reçue se déplace, par effet Doppler, à la vitesse V, le coefficient de variation linéaire C'(n) de la phase locale est égal à C(n) + [$\delta$(n+1) - $\delta$(n)] avec C(n) égal à [P(n) - P(n-1)]/T et $\delta$(n+1) égal à 3/2.V(n).T, et **en ce qu'**en cohérence, le nouveau discriminateur $\theta$'(n) est égal à $\theta$(n) + ½ [ $\delta$(n-1) + $\delta$(n-2) ], en notant P(n) la valeur de la phase et V(n) la vitesse de variation de la phase à l'instant nT.

6. Dispositif de réception de signaux de radionavigation par satellite selon la revendication 5, **caractérisé en ce que**, lorsque la phase reçue se déplace, par effet Doppler, à la vitesse V avec l'accélération A, le coefficient de variation linéaire C'(n) de la phase locale est égal à C(n) + [$\delta$(n+1) - $\delta$(n)] avec C(n) égal à [P(n) - P(n-1)]/T et $\delta$(n+1) égal à 3/2.[V(n) +2.A(n).T].T, et **en ce qu'**en cohérence le nouveau discriminateur $\theta$'(n) est égal à $\theta$(n) + ½ [ $\delta$(n-1) + $\delta$(n-2) ], en notant A(n) l'accélération de la phase reçue à l'instant nT.

**Patentansprüche**

1. Vorrichtung zum Empfangen von Satellitenfunknavigationssignalen (S), wobei die empfangenen Signale mit einer ersten Frequenz, Trägerfrequenz genannt, gesendet werden, wobei die Vorrichtung wenigstens Mittel zum Erzeugen eines lokalen Signals mit einer zweiten Frequenz, lokale Frequenz genannt, und eine Verfolgungsvorrichtung umfasst, die eine Feedback-Schleife, Trägerschleife genannt, umfasst, die Phasenverriegelung der lokalen Frequenz auf der Trägerfrequenz zulässt, wobei die Feedback-Schleife einen Hardware-Teil (Co, $I_{COR}$, Bo, NCO, PL) und einen Software-Teil ($D_P$, $C_P$) umfasst, wobei der Hardware-Teil wenigstens einen Integrator ($I_{COR}$) umfasst, der die Korrelation zwischen dem lokalen Signal und dem Empfängersignal durchführt, wobei das Signal von der Korrelation als korreliertes Signal bezeichnet wird, wobei die Korrelation auf einer hohen Frequenz durchgeführt wird, wobei der Software-Teil die Funktionen des Diskriminierens ($D_P$) der Phase des korrelierten Signals und des Filterns der Phase durchführt, wobei der Software-Teil auf einer tiefen Frequenz arbeitet, wobei die Dauer eines Grundrechenzyklus mit T bezeichnet wird, wobei jeder Zyklus durch eine ganze Zahl n indexiert wird, so dass die Dauer eines Zyklus innerhalb des Zeitintervalls [(n-1)T, nT] liegt, wobei das zum Zeitpunkt nT korrelierte Signal mit Zp(n) bezeichnet wird, wobei das Signal $\theta$(n) von der Diskrimination gleich dem Argument des Produkts von Zp(n) multipliziert mit einer komplexen Exponentialfunktion $Z_R$(n) ist, deren Argument ein Kompensationsterm in Abhängigkeit von n und von T ist,

**dadurch gekennzeichnet, dass**, wenn C(n) den linearen Variationskoeffizienten der Phase der lokalen Frequenz $\varphi_{lokal}$ zwischen den Zeitpunkten nT und (n+1)T bedeutet, so dass $\varphi_{lokal}$((n+1)T) = $\varphi_{lokal}$(nT) + T.C(n) ist, wobei C(n) zuvor auf der Basis der zum Zeitpunkt (n-1)T jeweils verfügbaren Daten berechnet wird, dieser Kompensationsterm gleich dem Gegenteil der Summe von C(n) und von ½ C(n-1) ist.

2.  Vorrichtung zum Empfangen von Satellitenfunknavigationssignalen nach Anspruch 1, **dadurch gekennzeichnet, dass**, wenn das empfangene Signal keine Daten umfasst, das Signal $\theta$(n) von der Diskrimination gleich dem Signal $\theta$(n-1) plus dem Argument ist, das auf dem Intervall ]-$\pi$, +$\pi$] des Produkts der komplexen Funktionen $Z_R$(n) und $Z_R$(n-1)* genommen wird.

3.  Vorrichtung zum Empfangen von Satellitenfunknavigationssignalen nach Anspruch 1, **dadurch gekennzeichnet, dass**, wenn das empfangene Signal Daten umfasst, das Signal $\theta$(n) von der Diskrimination gleich dem Signal $\theta$(n-1) plus dem Argument ist, das auf dem Intervall ]-$\pi$/2, +$\pi$/2] des Produkts der komplexen Funktionen $Z_R$(n) und $Z_R$(n-1)* genommen wird.

4.  Vorrichtung zum Empfangen von Satellitenfunknavigationssignalen (S), wobei die empfangenen Signale auf einer ersten Frequenz, Trägerfrequenz genannt, gesendet werden, wobei die Vorrichtung wenigstens Mittel zum Erzeugen eines lokalen Signals mit einer zweiten Frequenz, lokale Frequenz genannt, und eine Verfolgungsvorrichtung umfasst, die eine Feedback-Schleife, Trägerschleife genannt, umfasst, die eine Phasenverriegelung der lokalen Frequenz auf der Trägerfrequenz zulässt, wobei die genannte Feedback-Schleife einen Hardware-Teil (Co, $I_{COR}$, Bo, NCO, PL) und einen Software-Teil ($D_P$, $C_P$) umfasst, wobei der Hardware-Teil wenigstens einen Integrator ($I_{COR}$) umfasst, der die Korrelation zwischen dem lokalen Signal und dem empfangenen Signal durchführt, wobei das Signal von der Korrelation als korreliertes Signal bezeichnet wird, wobei die Korrelation auf einer hohen Frequenz durchgeführt wird, wobei der Software-Teil die Funktionen des Diskriminierens ($D_P$) der Phase des korrelierten Signals und des Filterns der Phase durchführt, wobei der Software-Teil auf einer tiefen Frequenz arbeitet, wobei die Dauer eines Grundrechenzyklus mit T bezeichnet wird, wobei jeder Zyklus um eine ganze Zahl n indexiert wird, so dass die Dauer eines Zyklus innerhalb des Zeitintervalls [(n-1)T, nT] liegt,

**dadurch gekennzeichnet, dass**, wenn das Zeitintervall in M Subintervalle der Dauer T/M unterteilt wird, die Subintervalle mit m referenziert werden, das zum Zeitpunkt (n+m/M).T korrelierte Signal mit Zp(n, m) bezeichnet wird, dann ist die Funktion Zp'(n) gleich der Summe der Produkte von Zp(n, m) mit einer komplexen Exponentialfunktion, deren Argument gleich -C(n-1)+(m-½).[C(n)-C(n-1)]/M ist, wobei C(n) der lineare Variationskoeffizient der Phase der lokalen Frequenz $\varphi_{lokal}$ zwischen den Zeitpunkten nT und (n+1)T ist, so dass [$\varphi_{lokal}$((n+1)T)-$\varphi_{lokal}$(nT)]/T gleich C(n) ist, wobei C(n) zuvor auf der Basis der zum Zeitpunkt (n-1)T verfügbaren Daten berechnet wurde, wobei das Signal $\theta$(n) von der Diskrimination gleich dem Argument des Produkts von Zp'(n) multipliziert mit einer komplexen Exponentialfunktion $Z_R$(n) ist, deren Argument gleich -1/2.C(n) ist.

5.  Vorrichtung zum Empfangen von Satellitenfunknavigationssignalen nach einem der Ansprüche 1 bis 3, **dadurch gekennzeichnet, dass**, wenn sich die empfangene Phase durch Doppler-Effekt mit der Geschwindigkeit V verschiebt, der lineare Variationskoeffizient C'(n) der lokalen Phase gleich C(n) + [$\delta$(n+1) - $\delta$(n)] ist, wobei C(n) gleich [P(n) - P(n-1)]/T ist und $\delta$(n+1) gleich 3/2.V(n).T ist, und dadurch, dass kohärent der neue Diskriminator $\theta$'(n) gleich $\theta$(n) + ½ [$\delta$(n-1) + $\delta$(n-2)] ist, wobei P(n) der Wert der Phase ist und V(n) die Variationsgeschwindigkeit der Phase zum Zeitpunkt nT ist.

6.  Vorrichtung zum Empfangen von Satellitenfunknavigationssignalen nach Anspruch 5, **dadurch gekennzeichnet, dass**, wenn sich die empfangene Phase durch Doppler-Effekt mit der Geschwindigkeit V mit der Beschleunigung A verschiebt, der lineare Variationskoeffizient C'(n) der lokalen Phase gleich C(n) + [$\delta$(n+1) - $\delta$(n)] ist, wobei C(n) gleich [P(n) - P(n-1)]/T ist und wobei $\delta$(n+1) gleich 3/2.[V(n)+2.A(n).T].T ist, und dadurch, dass kohärent der neue Diskriminator $\theta$'(n) gleich $\theta$(n) + ½ [$\delta$(n-1) + $\delta$(n-2)] ist, wobei A(n) die Beschleunigung der zum Zeitpunkt nT empfangenen Phase bedeutet.

**Claims**

1. A device for receiving satellite radionavigation signals (S), said received signals being transmitted at a first frequency, called carrier frequency, said device comprising at least means for generating a local signal at a second frequency, called local frequency, and a tracking device comprising a feedback loop, called carrier loop, allowing phase-locking of the local frequency on the carrier frequency, said feedback loop comprising a hardware portion (Co, $I_{COR}$, Bo, NCO, PL) and a software portion ($D_P$, $C_P$), said hardware portion comprising at least one integrator ($I_{COR}$) that carries out the correlation between the local signal and the received signal, the signal derived from the correlation being called correlated signal, said correlation being carried out at high frequency, said software portion carrying out the functions of discriminating ($D_P$) the phase of the correlated signal and filtering said phase, said software portion working at low frequency, the duration of a basic computation cycle being denoted T, each cycle being indexed by an integer n so that the duration of a cycle is within the time interval [(n-1)T, nT], the signal correlated at the instant nT being denoted Zp(n), the signal $\theta$(n) derived from the discrimination being equal to the argument of the product of Zp(n) multiplied by a complex exponential function $Z_R$(n), the argument of which is a compensation term that is a function of n and of T,
   **characterised in that**, if C(n) denotes the linear variation coefficient of the phase of the local frequency $\varphi_{local}$ between the instants nT and (n+1)T, such that $\varphi_{local}$((n+1)T) = $\varphi_{local}$(nT) + T.C(n), with C(n) being previously computed on the basis of the data respectively available at the instant (n-1)T, then this compensation term is equal to the opposite of the sum of C(n) and of ½ C(n-1).

2. The device for receiving satellite radionavigation signals according to claim 1, **characterised in that**, when the received signal does not comprise data, the signal $\theta$(n) derived from the discrimination is equal to the signal $\theta$(n-1) plus the argument taken on the interval ]-$\pi$, +$\pi$] of the product of the complex functions $Z_R$(n) and $Z_R$(n-1)*.

3. The device for receiving satellite radionavigation signals according to claim 1, **characterised in that**, when the received signal comprises data, the signal $\theta$(n) derived from the discrimination is equal to the signal $\theta$(n-1) plus the argument taken on the interval ]-$\pi$/2, +$\pi$/2] of the product of the complex functions $Z_R$(n) and $Z_R$(n-1)*.

4. A device for receiving satellite radionavigation signals (S), said received signals being transmitted at a first frequency, called carrier frequency, said device comprising at least means for generating a local signal at a second frequency, called local frequency, and a tracking device comprising a feedback loop, called carrier loop, allowing phase-locking of the local frequency on the carrier frequency, said feedback loop comprising a hardware portion (Co, $I_{COR}$, Bo, NCO, PL) and a software portion ($D_P$, $C_P$), said hardware portion comprising at least one integrator ($I_{COR}$) that carries out the correlation between the local signal and the received signal, the signal derived from the correlation being called correlated signal, said correlation being carried out at high frequency, said software portion carrying out the functions of discriminating ($D_P$) the phase of the correlated signal and filtering said phase, said software portion working at low frequency, the duration of a basic computation cycle being denoted T, each cycle being indexed by an integer n so that the duration of a cycle is within the time interval [(n-1)T, nT],
   **characterised in that**, with said time interval being divided into M sub-intervals of duration T/M, said sub-intervals being denoted m, the signal correlated at the instant (n+m/M).T being denoted Zp(n, m), then the function Zp'(n) is equal to the sum of the products of Zp(n, m) by a complex exponential function, the argument of which equals - C(n-1)+(m-½).[C(n)-C(n-1)]/M, with C(n) being the linear variation coefficient of the phase of the local frequency $\varphi_{local}$ between the instants nT and (n+1)T, such that [$\varphi_{local}$((n+1)T)-$\varphi_{local}$(nT)]/T is equal to C(n), with C(n) being previously computed on the basis of the data available at the instant (n-1)T, the signal $\theta$(n) derived from the discrimination being equal to the argument of the product of Zp'(n) multiplied by a complex exponential function $Z_R$(n), the argument of which equals -1/2.C(n).

5. The device for receiving satellite radionavigation signals according to any one of claims 1 to 3, **characterised in that**, when the received phase shifts, by Doppler effect, at the speed V, the linear variation coefficient C'(n) of the local phase is equal to C(n) + [$\delta$(n+1) - $\delta$(n)], with C(n) being equal to [P(n) - P(n-1)]/T and $\delta$(n+1) being equal to 3/2.V(n).T, and **in that**, coherently, the new discriminator $\theta$'(n) is equal to $\theta$(n) + ½ [$\delta$(n-1) + $\delta$(n-2)], with P(n) denoting the value of the phase and V(n) the variation speed of the phase at the instant nT.

6. The device for receiving satellite radionavigation signals according to claim 5, **characterised in that**, when the received phase shifts, by Doppler effect, at the speed V with the acceleration A, the linear variation coefficient C'(n) of the local phase is equal to C(n) + [$\delta$(n+1) - $\delta$(n)], with C(n) being equal to [P(n) - P(n-1)]/T and $\delta$(n+1) being equal to 3/2.[V(n)+2.A(n).T].T, and **in that**, coherently, the new discriminator $\theta$'(n) is equal to $\theta$(n) + ½ [$\delta$(n-1) + $\delta$(n-2)], with A(n) denoting the acceleration of the phase received at the instant nT.

P

C.E

S.

A.

T.F.(A)

FIG. 1

FIG. 2

FIG. 3

FIG. 4

FIG. 5

FIG. 6

FIG. 7

**Sans données :**

FIG. 8

**Avec données :**

FIG. 9

**Sans données :**

θ Arctangente

+π

Ecart de phase

-π

θ arctangente étendu

FIG. 10

**Avec des données :**

θ simple

+π/2

Ecart de phase

-π/2

θ étendu

FIG. 11

FIG. 12

FIG. 13

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **HINEDI.** Digital Accumulators in phase and frequency tracking Loops. *IEEE Transactions on Aerospace and Electronic Systems,* Janvier 1990, vol. 26 (1